# EUROPEAN PATENT APPLICATION

(11) **EP 4 749 686 A1**
(43) Date of publication of application: **27.05.2026**
(21) Application number: 24214458.2
(22) Date of filing: 21.11.2024
(51) Int. Cl.: H01L 23/495

(54) **SEMICONDUCTOR MODULE AND METHOD FOR MANUFACTURING**

(71) Applicant: Hitachi Energy Ltd, 8050 Zürich (CH)
(72) Inventor: Santolaria, Lluis, 4600 Olten (CH); Truessel, Dominik, 5620 Bremgarten (CH); Maleki, Milad, 5417 Untersiggenthal (CH); Beyer, Harald, 5600 Lenzburg (CH)
(74) Representative: Michalski Hüttermann & Partner Patentanwälte mbB

(57) **Abstract**

The invention relates to a semiconductor module (10) comprising a molded housing (12), several terminals (14) and a support member (16), wherein the housing (12) comprises a side surface (18) and a top surface (20), the top surface (20) not being parallel to the side surface (18), wherein at least two terminals (14) protrude from the side surface (18) of the housing (12), wherein the support member (16) is positioned on the top surface (20) at least partially within a perimeter defined by the top surface (20), wherein the support member is attached to at least two terminals (14) such that the terminals (14) are spaced apart from each other and such that an outer end (22) of the terminal (14) is located within the perimeter defined by the top surface (20), and wherein the support member (16) and the housing (12) are configured as separate components.

Furthermore, the invention relates to a method for manufacturing the above semiconductor module (10).

## Description

### Technical Field

The invention relates to a semiconductor module comprising a molded housing, several terminals and a support member.

Furthermore, the invention relates to a method for manufacturing the semiconductor module.

### Background Art

Semiconductor modules are generally widely known in the art. For protection of the semiconductor devices, such as IGBT, MOSFETs, or HEMTs of the semiconductor module, the semiconductor module typically comprises a molded housing that encapsulates the semiconductor devices. The housing may be formed in a transfer molding process using a molding compound. Transfer molding is a manufacturing process where the molding compound is forced into a mold.

For connecting the semiconductor module to the external power source and/or to its application, typically via a busbar, the semiconductor module comprises power terminals. In order to send control signals to the semiconductor device and/or for sensing purposes, the semiconductor module typically comprises control terminals. It is known to provide the terminals by a lead-frame being interconnected with a substrate of the semiconductor module to ensure mechanical stability.

Using lead-frames to provide the terminals however causes the terminals to protrude from a side surface of the housing in a horizontal fashion.

In case external circumstances - such as customer demand - require that the terminals protrude from a top surface in a vertical fashion, it is possible to use vertical pins protruding from the top surface of the molded housing, instead of a lead-frame.

However, such vertical pins increase the complexity of the power module, leading to higher costs.

Alternatively to vertical pins, a lead-frame can be used and the terminals that protrude from the side surface of the housing in a horizontal fashion can be bended upwards. It is however challenging to achieve a high mechanical stability with such a solution, when the terminals of the semiconductor module are connected with printed circuit boards in a customer application. Furthermore, vertical pins do not allow for a high freedom of design and the adaption to the customer needs regarding the location of the pins is hardly possible. Therefore, means to increase the mechanical stability, increase the design freedom and/or simplify the manufacturing process for semiconductor power modules are desirable.

### Summary of invention

It is an object of the invention to provide means to increase the design freedom for terminals of semiconductor modules, improve the mechanical stability and/or to simplify the manufacturing process of semiconductor modules.

The object of the invention is solved by the features of the independent claims. Modified embodiments are detailed in the dependent claims.

Thus, the object is solved by a semiconductor module comprising a molded housing, several terminals and a support member, wherein the housing comprises a side surface and a top surface, the top surface not being parallel to the side surface, wherein at least two terminals protrude from the side surface of the housing, wherein the support member is positioned on the top surface at least partially within a perimeter defined by the top surface, wherein the support member is attached to at least two terminals are such that the terminals are spaced apart from each other and such that an outer end of the terminal is located within the perimeter defined by the top surface, and wherein the support member and the housing are configured as separate components.

Additionally, the object is solved by a method for manufacturing a semiconductor module, comprising the steps of
- Providing a semiconductor module comprising a molded housing and several terminals, wherein the housing comprises a side surface and a top surface, the top surface not being parallel to the side surface, wherein at least two terminals protrude from the side surface of the housing in the same direction in a straight fashion and wherein a support member is attached to the at least two terminals protruding from the side surface, such that the terminals are spaced from each other; and
- Bending the terminals attached on the support member such that the support member is positioned on the top surface at least partially within a perimeter defined by the top surface and an outer end of the terminal is located within the perimeter defined by the top surface.

One aspect of the invention is that the semiconductor module comprises the support member on the top surface, wherein the support member is attached to at least two terminals such that the terminals are spaced apart from each other and such that the outer end of the terminals are located within the perimeter defined by the top surface. The support member is preferably a one-piece component, which fixes the at least two terminals together and with respect to each other. In other words, the support member enhances the mechanical stability and thus also simplifies manufacturing by not only fixing one terminal, but at least two terminals. In particular the support member being attached to multiple terminals facilitates the simultaneous bending of the multiple terminals. Additionally, the support member makes the bending process easier due to improved mechanical stability of the terminals. The support member further simplifies the alignment of the terminals on the top surface. The support member also improves mechanical support in the situation when the terminals of the semiconductor module are connected with printed circuit boards in customer application, in particular in cases when the terminals are configured as pin terminals with press-fit contacts.

A further aspect of the invention is also that the support member and the molded housing are not configured as one-piece component or integral part but are configured as separate components. To have the support member and the housing as separate components allows for a high design freedom to place the support member on the top surface in a desired location. Thus, the location and in particular the location of the outer end of the terminals can easily be adjusted and can also be influenced by the position of the support member. The location of the outer end of the terminals for example needs to be adjusted to customer need e.g. based on the location of holes in the printed circuit board for insertion of the pin terminals. Additionally, it is also possible to adjust the location of the outer end of the terminals by changing the dimensions, the design and/or the layout of the support member, which further increases design freedom.

The support member also allows to influence the electromagnetic behaviour of the power module, as depending on the position of the support member on the top surface relative to a position of an electric component inside the housing favourable coupling behaviour can be achieved.

Regarding the semiconductor module, it is preferred that the semiconductor module is configured as power semiconductor module. The semiconductor module preferably comprises at least one electric component, preferably a semiconductor device and further preferably at least one power semiconductor device, such as an IGBT (insulated-gate bipolar transistor), MOSFET (metal-oxide-semiconductor field-effect transistor), or HEMT (high-electron-mobility transistor).

The semiconductor device is preferably arranged inside the molded housing such that the housing encapsulates the semiconductor device. The housing preferably has a cuboidal shape with a top surface and opposite to the top surface a bottom surface. The bottom surface of the housing might be configured to be connected to a cooler, or alternatively a cooling structure can be incorporated into the bottom surface, or into the housing. The top surface and the bottom surface are preferably connected to each other by the side surface. Thus, the side surface and the top surface are not parallel to each other.

According to a preferred embodiment of the invention the semiconductor device is selected from any of MOSFET, IGBT, BJT, Thyristor, GTO, JFET, HEMT, and diodes. Further preferably the semiconductor device is a Silicon power semiconductor device, or a wide-bandgap power semiconductor device, for example a Silicon-Carbide power semiconductor device and/or a Gallium-Nitride power semiconductor device. This has the advantage that fast switching can be achieved.

Further preferably the semiconductor module is configured for a voltage in between 600 V to 20 kV. Further preferably the semiconductor module comprises only few - i.e. less than 20 - wide-band gap semiconductor devices connected in parallel.

The semiconductor module comprises several terminals, preferably for connecting the semiconductor module to an external power source and/or to its application, i.e. power terminals and/or for sending control signals or sensing signals to the semiconductor module, i.e. control terminals. At least two terminals protrude from the side surface of the housing. Preferably, these at least two terminals protrude in the same direction from the side surface of the housing.

The at least two terminals, which protrude from the side surface, and preferably all the terminals each comprise the outer end and an inner end, wherein the outer end is located outside of the housing and the inner end is located inside the housing. Further preferably the inner end is at least indirectly electrically connected to one or more semiconductor devices of the semiconductor module.

Within the housing the one or more semiconductor devices are preferably mounted to an isolating substrate with a structured circuit metallization on top and a homogeneous bottom metallization on its back side. The inner end of the terminal is preferably electrically connected to the circuit metallization, for example by welding or soldering.

Preferably, all terminals of the semiconductor module protrude from the side surface of the housing. Further preferably the terminals are provided by a lead frame. Preferably, the lead frame provides internal terminal portions that are connected to the circuit metallization. Alternatively, the lead frame may comprise a central die pad for placing the semiconductor device, wherein the central die pad is preferably surrounded by leads, which are metal conductors leading away from the semiconductor to the outside of the housing. The end of each lead closest to the semiconductor device preferably ends in a bond pad. Further preferably bond wires electrically connect the semiconductor device to each bond pad.

As the lead frame is preferably manufactured by removing material, e.g. by an etching or stamping process, from a flat plate of metal, typically copper or copper alloy, it provides a high mechanical stability and provides an overall rigid structure, which makes the whole lead frame easy to handle automatically. The metal of the lead frame and/or the terminals may be coated by a noble metal or by nickel to achieve a better adhesion of the material of the support member and/or of the housing.

As already mentioned, the support member is positioned on the top surface at least partly within the perimeter defined by the top surface. Preferably, the support member is positioned on the top surface within the perimeter defined by the top surface. In other words, the support member preferably does not protrude over the edge between the top surface and the side surface. This ensures that the semiconductor module is compact. The support member can be positioned in the centre of the top surface or in a border area of the top surface. The support member is attached to the at least two terminals such that the terminals are spaced apart from each other. This ensures electrical isolation between the at least two terminals. It is further possible that more than two terminals are attached to the support member. Preferably all the control terminals and/or all the power terminals protruding from the side surface in the same direction are fixed to the same support member. This further increases the mechanical stability, in particular during the bending process, and simplifies alignment of the terminals.

The at least two terminals are further fixed to the support member and the support member is arranged in such a way that the outer end of the terminal is located within the perimeter defined by the top surface. Thus, in other words, the terminals protruding from the side surface of the housing are bent in such a way that their outer ends are within the perimeter defined by the top surface, and preferably defined by the edge between the top surface and the side surface. The terminal can be bent in such a way, that the terminal comprises large, curved portions or several large, curved portions and no straight portions. The terminal can also be bent in such a way that it comprises straight portions and curved portions. The terminal can also comprise mainly straight portions and only small, curved portions defined by the bending of the terminal.

According to a preferred embodiment of the invention, the at least to terminals are configured such that a portion of the terminal directly adjacent to the outer end extends perpendicular ± 30 degrees to the top surface. In other words, the terminal is preferably bent in such a way that its end portion extends in a vertical manner. The vertical portions make it very easy to connect the terminals for example with a printed circuit board being arranged above the semiconductor module.

According to a further preferred embodiment of the invention the at least two terminals comprise each two portions extending parallel ± 30 degrees to the top surface and each two portions extending perpendicular ± 30 degrees to the top surface. As the at least two terminals protrude from the side surface of the housing they preferably comprise a first portion extending parallel ± 30 degrees to the top surface in a horizontal fashion. Due to the bending, adjacent to the first portion there is preferably a second portion where the terminal extends perpendicular ± 30 degrees to the top surface in a vertical fashion upwards. Adjacent to this portion there is preferably a third portion where again the terminal extending parallel ± 30 degrees to the top surface in a horizontal fashion. The support member is preferably arranged at least partly and preferably fully in this third portion of the terminal. Adjacent to the third portion there is preferably the end portion, where the terminal extends perpendicular ± 30 degrees to the top surface in a vertical fashion.

In this regard and according to another preferred embodiment of the invention, wherein at least one of the two portions extending parallel ± 30 degrees to the top surface also extends perpendicular ± 30 degrees to the side surface. In other words, the first portion preferably protrudes perpendicularly ± 30 degrees from the side surface and/or the third portion preferably extends not only parallel ± 30 degrees to the top surface in a horizontal fashion but also perpendicularly ± 30 degrees with regard to the side surface. Further preferably, the third portion extends towards a centre of the top surface and thus extends in a direction opposite to the first portion of the terminal, where the terminal extends away from the centre.

According to another preferred embodiment of the invention, the at least two terminals are configured as power terminal and/or as control terminal. Particularly preferably the at least two terminals are configured as control terminals. In this regard it is further preferred that a semiconductor module is provided comprising several control terminals, wherein all control terminals that protrude from the side surface of the housing in the same direction are attached to a common support member such that the control terminals are spaced apart from each other and such that the outer ends of the control terminals are located within the perimeter defined by the top surface. It is particularly beneficial to have the outer end of all the control terminals within the perimeter of the top surface, in particular when the outer portion extends in a vertical manner.

In connection to this and according to a further preferred embodiment of the invention, the outer end of the at least two terminals is configured as pin contact or press fit contact. This makes connection of the terminals to further components particularly easy.

According to another preferred embodiment of the invention, the at least two terminals are preferably partly embedded in the support member. This ensures a stable fixation of the terminals to the support member. The support member is preferably attached to the at least to terminals by a molding process, which makes it particularly easy to embed the terminals at least partly in the support member.

According to another preferred embodiment of the invention, the support member comprises a recess and the top surface comprises a corresponding protruding portion matching the recess. Alternatively or additionally, it is preferred that the support member comprises a protruding portion, and that the top surface comprises a corresponding recess matching the protruding portion. Further alternatively or additionally, it is preferred that the top surface comprises a recess, and preferably one recess, matching a footprint of the support member. Recesses and corresponding protrusions in the housing and the support member facilitate the proper placement of the support member on the top surface, without increasing the complexity for manufacturing. For example, the housing may comprise a groove or recess corresponding to the form of the support member. Recesses and corresponding protrusions in the housing and the support member further facilitate proper anchoring of the support member on the top surface.

It is possible that the support member is arranged on the top surface of the housing and as several terminals are fixed to the support member no further measures are needed to achieve a high mechanical stability. However, it is also possible to increase the mechanical stability by a form-fit connection such as the above-described matching protrusions and recesses. It is further possible to connect the support member to the top surface by a bonded connection. In this regard and according to a further preferred embodiment of the invention, the support member is connected to the top surface by gluing, welding, clamping, and/or screwing.

As already mentioned, the support member can be positioned in the centre of the top surface or in a border area of the top surface. The support member is located such that the outer end of the terminals fixed to the support member are located within the perimeter defined by the top surface, and preferably defined by the edge between the top surface and the side surface. It is however more preferable to position the support member away from the border of the top surface. In this regard and according to a further preferred embodiment of the invention, the perimeter defined by the top surface excludes an outer circumferential edge of the top surface, the outer circumferential edge corresponding to at least 10% of a surface area of the top surface. As the outer end of the terminal is located more in the centre of the top surface favourable electromagnetic coupling for example regarding inductive coupling with the electric components inside the housing, and in particular with terminal portions, substrate, and/or wirebonds inside the housing, can be achieved, as the inductive coupling is mainly caused by the third portion of the terminal.

The support member can have any form. Preferably however the support member has a cuboidal shape. The form of the support member is preferably adjusted to the number of terminals that are fixed to the support member. The support member can be attached to the at least to terminals by form-fit connections. For example, the support member can have grooves for the terminals. It is further possible that the at least two terminals are embedded in the support member. Alternatively or additionally, the support member can be attached to the at least to terminals by a bonded connections.

In a preferred embodiment of the invention, the support member is attached to the at least two terminals by a molding process and particularly by an injection molding process or by a transfer molding process. This is an easy way to embed the at least two terminals in the support member.

In this regard and according to a further preferred embodiment of the invention, the support member comprises a thermosetting resin, a thermoplastic resin or other electrical insulating materials that are moldable. The material of the support member may contain any kind of fillers like particles or fibers.

As already mentioned, the support member being a separate component from the housing allows to influence the electromagnetic behaviour of the power module, as depending on the position of the support member on the top surface and consequently of the embedded terminals relative to the position of an electric component, and in particular the terminal portions, the substrate, and/or the wirebonds, inside the housing a favourable electromagnetic coupling behaviour can be achieved. In connection to this and according to a further preferred embodiment of the invention it is preferred that the semiconductor module or the support member comprises a layer of conductive material in between the top surface and the at least two terminals. The layer of conductive material is preferably spaced apart from the at least two terminals. The layer of conductive material can be formed within the support member. Alternatively, the layer of conductive material can be formed on the outside of the support member for example by coating the support member. It is further possible to arrange the layer of conductive material on the top surface. The layer of conductive material may improve the electromagnetic shielding of the terminals with respect to the sem iconductor devices and/or with respect to the internal wiring structure within the molded housing.

Further technical aspects and advantages of the invention will be apparent for the skilled person from the following description of the method for manufacturing the semiconductor module.

As already mentioned, the object is also solved by the method for manufacturing the semiconductor module, comprising the steps of
- Providing the semiconductor module comprising a molded housing and several terminals, wherein the housing comprises the side surface and the top surface, the top surface not being parallel to the side surface, wherein at least two terminals protrude from the side surface of the housing in the same direction in a straight fashion and wherein the support member is attached to the at least two terminals protruding from the side surface, such that the terminals are spaced from each other; and
- Bending the terminals attached to the support member such that the support member is positioned on the top surface at least partially within a perimeter defined by the top surface and the outer end of the terminal is located within the perimeter defined by the top surface.

One aspect of the method is that the support member is attached to the at least two terminals protruding from the side surface in a straight fashion before the bending of the terminals. Thus, the support member being attached to more than one terminal enhances the mechanical stability during the bending process. The bending of the terminals is preferably performed by a trim and form process.

According to another preferred embodiment of the invention, the step of bending the terminals attached to the support member comprises bending the terminals such that a portion of the terminal directly adjacent to the outer end extends perpendicular ± 30 degrees to the top surface. The terminals are thus not only bent towards the centre of the housing but such that the end portion is located inside the perimeter of the top surface and extends in a vertical fashion.

According to one preferred alternative embodiment of the invention the step of providing the semiconductor module comprises providing a semiconductor module comprising a molded housing and several terminals, and attaching the support member to the at least two terminals protruding from the side surface of the housing in the same direction in a straight fashion. In other words, in this preferred alternative, the housing is molded and afterwards the support member is fixed to the at least two terminals. It is possible that attaching the support member to the at least two terminals comprises a further molding step such as transfer molding or injection molding. However, it is also possible that fixing the support member to the at least two terminals comprises inserting the terminals into recesses, grooves and/or openings of the support member; and/or gluing and/or clamping the support member to the at least two terminals.

According to one preferred alternative embodiment of the invention the step of providing the semiconductor module comprises providing a semiconductor module being free of a housing, and molding a housing, and molding a support member to the at least two terminals protruding in the same direction in a straight fashion, and wherein the molding of the housing and the molding of the support member are performed in the same molding step. In other words, in this preferred alternative, the housing and the support member are molded in the same processing step. This makes manufacturing particularly cost efficient.

These and other aspects of the invention will be apparent from and elucidated with reference to the embodiments described hereinafter.

In the drawings:
- Fig. 1: schematically shows a top view of a semiconductor module according to a preferred embodiment of the invention,
- Fig. 2: schematically shows a side view of the semiconductor module from figure 1, and
- Fig. 3: schematically shows steps of a method for manufacturing the semiconductor module of figure 1.

### Description of embodiments

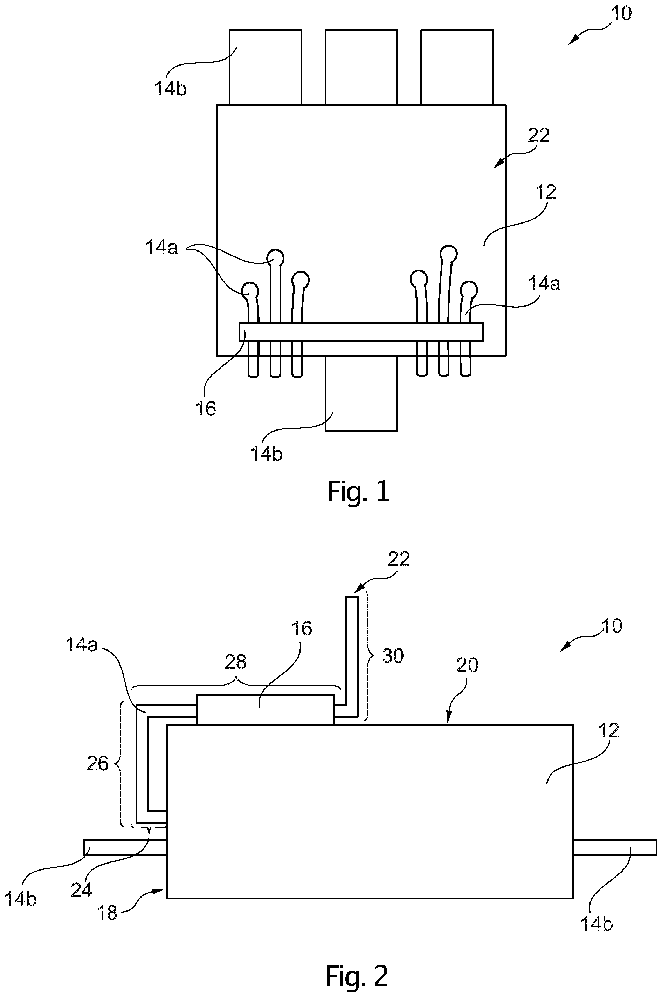

Figures 1 and 2 schematically show different views of a semiconductor module 10 according to a preferred embodiment of the invention. The semiconductor module 10 comprises a molded housing 12, several terminals 14a, 14b and a support member 16. In this embodiment the semiconductor module 10 comprises six control terminals 14a and four power terminals 14b. The support member 16 and the housing 20 are configured as separate components.

As is visible in figure 2 the housing 12 comprises a side surface 18 and a top surface 20, the top surface 20 not being parallel to the side surface 18. As is visible in figure 1 at least two terminals 14, in this case all six control terminals 14a protrude from the side surface 18 of the housing 12. Also the four power terminals 14 protrude form the side surface 18 of the housing 12.

The support member 16 is positioned on the top surface 20 within a perimeter defined by the top surface 20. In this embodiment the support member 16 has a cuboidal shape and is not located directly at the edge of the top surface 20 and the side surface 18, but a bit shifted towards the centre of the housing 12. The support member 16 is attached to at least two terminals 14. In this embodiment the six control terminals 14a are attached to the support member 16 such that the terminals 14a are spaced apart from each other and such that an outer end 22 of the terminal 14a is located within the perimeter defined by the top surface 20.

As is particularly easy visible in figure 2, the terminals 14a that protrude from the side surface 18 of the housing 12 comprise a first portion 24 extending essentially parallel to the top surface 20 in a horizontal fashion. The terminals 14b are however bent such that, adjacent to the first portion 24 there is a second portion 26 where the terminal 14a extends essentially perpendicular to the top surface 20 in a vertical fashion upwards. Adjacent to this second portion 26 there is third portion 28 where again the terminal 14a extending essentially parallel to the top surface 20 in a horizontal fashion towards a centre of the housing 12. The support member 16 is arranged in this third portion 28 of the terminal 14a. Adjacent to the third portion 28 there is an end portion 30 with the outer end 22, where the terminal extends essentially perpendicular to the top surface 20 in a vertical fashion. A bottom side of the support member 16 rests on the top surface 20 of the housing 12.

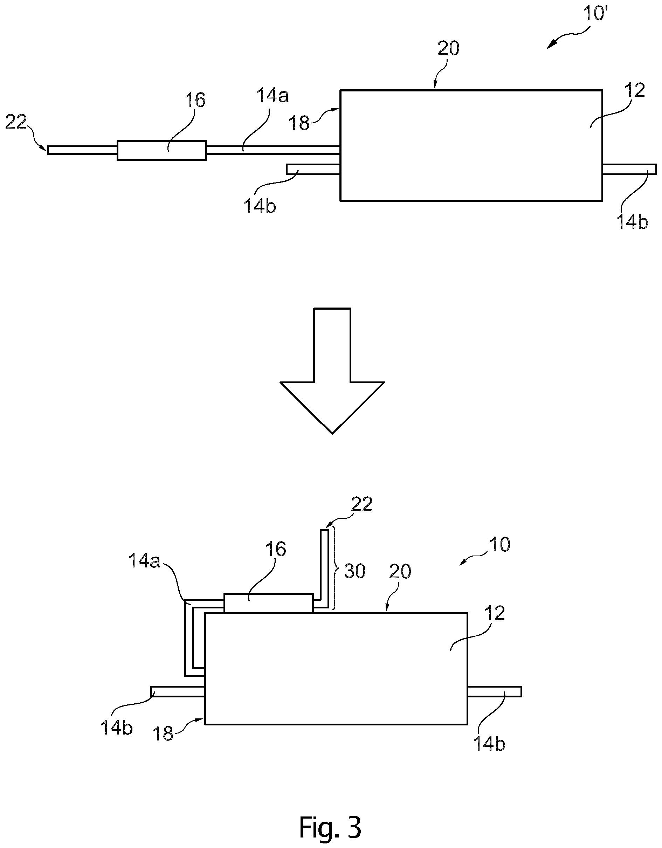

Figure 3 schematically shows steps of a method for manufacturing the semiconductor module 10 of figure 1.

In a first step of the method a semiconductor module 10' comprising the molded housing 12 and several terminals 14 is provided. The housing 12 comprises the side surface 18 and the top surface 20, the top surface 20 not being parallel to the side surface 18. At least two terminals 14a protrude from the side surface 18 of the housing 12 in the same direction in a straight fashion. The support member 16 is attached to the at least two terminals 14a protruding from the side surface, such that the terminals 14a are spaced from each other.

In a further step of the method, the terminals 14a attached to the support member 16 are bent such that the support member 16 is positioned on the top surface 20 within the perimeter defined by the top surface 20 and such that the outer end 22 of the terminal 14a is located within the perimeter defined by the top surface 20, in order to achieve the power module 10. The bending can be performed in one bending step or in more than one bending steps.

In this embodiment the housing 12 and the support member 16 are manufactured by transfer molding. Hence, the terminal 14a is embedded in the support member 16. Furthermore, the housing 12 and the support member 16 are molded in the same processing step.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosed, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: semiconductor module
- 12: molded housing
- 14a: control terminals
- 14b: power terminals
- 16: support member
- 18: side surface
- 20: top surface
- 22: outer end of terminal
- 24: first portion
- 26: second portion
- 28: third portion
- 30: end portion

## Claims

1. Semiconductor module (10) comprising a molded housing (12), several terminals (14) and a support member (16),
wherein the housing (12) comprises a side surface (18) and a top surface (20), the top surface (20) not being parallel to the side surface (18),
wherein at least two terminals (14) protrude from the side surface (18) of the housing (12),
wherein the support member (16) is positioned on the top surface (20) at least partially within a perimeter defined by the top surface (20), wherein the support member (16) is attached to at least two terminals (14) such that the terminals (14) are spaced apart from each other and such that an outer end (22) of the terminal (14) is located within the perimeter defined by the top surface (20), and
wherein the support member (16) and the housing (12) are configured as separate components.

2. Semiconductor module (10) according to claim 1, wherein the at least to terminals (14) are configured such that a portion (30) of the terminal (14) directly adjacent to the outer end (22) extends perpendicular ± 30 degrees to the top surface (20).

3. Semiconductor module (10) according to any of the previous claims, wherein the at least two terminals (14) comprise each two portions (24, 28) extending parallel ± 30 degrees to the top surface (20) and each two portions (26, 30) extending perpendicular ± 30 degrees to the top surface (20).

4. Semiconductor module (10) according to the previous claim, wherein at least one of the two portions (24, 28) extending parallel ± 30 degrees to the top surface (20) also extends perpendicular ± 30 degrees to the side surface (18).

5. Semiconductor module (10) according to any of the previous claims, wherein the at least two terminals (14) are configured as power terminal (14b) and/or as control terminal (14a); and/or wherein the at least two terminals (14) are at least partly embedded in the support member (16).

6. Semiconductor module (10) according to any of the previous claims, wherein the outer end (22) of the at least two terminals (14) is configured as pin contact or press fit contact.

7. Semiconductor module (10) according to any of the previous claims, wherein the support member (16) comprises a recess and wherein the top surface (20) comprises a corresponding protruding portion matching the recess; and/or wherein the support member (16) comprises a protruding portion, and wherein the top surface (20) comprises a corresponding recess matching the protruding portion; and/or wherein the top surface (20) comprises a recess matching a footprint of the support member (16).

8. Semiconductor module (10) according to any of the previous claims, wherein the support member (16) is connected to the top surface (20) by gluing, welding, clamping, or screwing.

9. Semiconductor module (10) according to any of the previous claims, wherein the perimeter defined by the top surface (20) excludes an outer circumferential edge of the top surface (20), the outer circumferential edge corresponding to at least 10% of a surface area of the top surface (20).

10. Semiconductor module (10) according to any of the previous claims, wherein the support member (16) comprises a thermosetting resin or a thermoplastic resin.

11. Semiconductor module (10) according to any of the previous claims, wherein the semiconductor module (10) or the support member (16) comprises a layer of conductive material in between the top surface (20) and the at least two terminals (14).

12. Method for manufacturing a semiconductor module (10), comprising the steps of
- Providing a semiconductor module (10') comprising a molded housing (12) and several terminals (14), wherein the housing (12) comprises a side surface (18) and a top surface (20), the top surface (20) not being parallel to the side surface (18), wherein at least two terminals (14) protrude from the side surface (18) of the housing (12) in the same direction in a straight fashion and wherein a support member (16) is attached to the at least two terminals (14) protruding from the side surface (18), such that the terminals (14) are spaced from each other; and
- Bending the terminals (14) attached to the support member (16) such that the support member (16) is positioned on the top surface (20) at least partially within a perimeter defined by the top surface (20) and an outer end (22) of the terminal (14) is located within the perimeter defined by the top surface (20).

13. Method according to the previous claim, wherein the step of bending the terminals (14) attached to the support member (16) comprises bending the terminals (14) such that a portion (30) of the terminal (14) directly adjacent to the outer end (22) extends perpendicular ± 30 degrees to the top surface (20).

14. Method according to any of claims 12 or 13, wherein the step of providing the semiconductor module (10') comprises providing a semiconductor module (10') comprising a molded housing (12) and several terminals (14), and attaching the support member (16) to the at least two terminals (14) protruding from the side surface (18) of the housing (12) in the same direction in a straight fashion.

15. Method according to any of claims 12 or 13, wherein the step of providing the semiconductor module (10') comprises providing a semiconductor module being free of a housing (12), and molding a housing (12), and molding a support member (16) to the at least two terminals (14) protruding in the same direction in a straight fashion, and wherein the molding of the housing (12) and the molding of the support member (16) are performed in the same molding step.
